# EUROPÄISCHE PATENTSCHRIFT

(11) **EP 1 839 472 B1**
(45) Veröffentlichungstag und Bekanntmachung des Hinweises auf die Patenterteilung: **07.05.2008**
(21) Anmeldenummer: 05823516.9
(22) Anmeldetag: 16.12.2005
(51) Int. Cl.: H05K 13/02

(54) **BESTÜCKAUTOMAT MIT VERRIEGELUNGSEINRICHTUNG ZUM KOPPELN EINER ZUFÜHREINRICHTUNG**
PICK-AND-PLACE MACHINE COMPRISING A LOCKING DEVICE FOR COUPLING A FEEDING UNIT TO IT
MACHINE A IMPLANTER DES COMPOSANTS COMPRENANT UN DISPOSITIF DE VERROUILLAGE POUR COUPLER UN DISPOSITIF D'AMENEE

(30) Priorität: 20.01.2005 DE 102005002798
(43) Veröffentlichungstag der Anmeldung: 03.10.2007
(73) Patentinhaber: SIEMENS AKTIENGESELLSCHAFT, 80333 München (DE)
(72) Erfinder: BEYER, Günter, 82110 Germering (DE); ESCHENWECK, Friedrich, 85622 Feldkirchen (DE); LIEBEKE, Thomas, 85521 Ottobrunn (DE); PALLAS, Dirk, 86899 Landsberg (DE); WORZISCHEK, Alexander, 82061 Neuried (DE)
(86) Internationale Anmeldenummer: PCT/EP2005/056840
(87) Internationale Veröffentlichungsnummer: WO 2006/076995

(56) Entgegenhaltungen:
- EP-A- 0 453 370
- JP-A- 2001 156 493
- JP-A- 2004 095 719
- US-A- 5 941 674
- US-B1- 6 675 056

## Beschreibung

Die Erfindung betrifft einen Bestückautomaten zum Bestücken von Substraten mit elektrischen Bauelementen, mit einer Verriegelungseinrichtung zum Ankoppeln einer Zuführeinrichtung, und eine Zuführeinrichtung und ein Steuerverfahren für einen solchen Bestückautomaten.

In Bestückautomaten werden Substrate mit elektrischen Bauelementen bestückt. Ein Bestückkopf des Bestückautomaten, der mittels eines Positioniersystems über einem Arbeitsbereich des Bestückautomaten verfahrbar ist, nimmt elektronische Bauelemente in einem Abholbereich des Bestückautomaten auf und transportiert diese zu einem Bestückbereich, wo die Substrate bestückt werden. Im Abholbereich werden die Bauelemente mittels einer oder mehrerer Zuführeinrichtungen, die meist seitlich entlang der Bestückstrecke am Bestückautomaten angekoppelt sind, bereitgestellt. Die Zuführeinrichtungen verfügen meist über eine eigene Transportmechanik mit elektrischem Antrieb, welche den Vorschub der meist in Form von Gurten gespeicherten Bauelemente gewährleistet. Die dafür notwendige elektrische Energie wird den Zuführeinrichtungen in der Regel vom Bestückautomaten bereitgestellt. Ferner weisen die Zuführeinrichtungen meist eigene Steuereinrichtungen auf, welche die internen Abläufe der Zuführeinrichtungen steuern. Die Steuereinrichtungen der Zuführeinrichtungen kommunizieren über eine Datenschnittstelle mit einer Steuereinrichtung des Bestückautomaten, welche alle Abläufe des Bestückprozesses überwacht.

Bei bisher bekannten Bestücksystemen, bestehend aus Bestückautomat und Zuführeinrichtungen, kann der Bediener die Zuführeinrichtungen einzeln nach eigenem Ermessen auch während des Betriebs des Bestückautomaten entweder direkt oder nach eigenhändiger Entriegelung eines meist mechanischen Fixiermechanismus von dem Bestückautomaten entnehmen. Sollte sich im Moment der Entnahme der Zuführeinrichtung gerade der Bestückkopf im Abholbereich des Bestückautomaten befinden, oder der Bestückkopf gerade Bauelemente aus der entsprechenden Zuführeinrichtung entnehmen, kann es zu einer Beschädigung des Bestückkopfs (Kopfcrash) und der Zuführeinrichtung kommen, was die gesamte Bestückanlage für längere Zeit außer Betrieb setzen kann.

Aus der Offenlegungsschrift EP-0453370 ist ferner ein Bestückautomat bekannt, bei dem die Zuführeinrichtungen mittels eines externen Steckerkabels mit dem Bestückautomaten verbunden werden müssen. Über eine derartige Steckerverbindung kann sowohl die Energiezufuhr als auch der Datenaustausch erfolgen. Eine derartige Steckerverbindung, die der Bediener nach eigenem Ermessen trennen kann, bringt den Nachteil mit sich, dass durch die plötzliche Trennung der Datenverbindung und der Stromzufuhr eine verlustfreie Datensicherung innerhalb der Zuführeinrichtung nicht mehr garantiert werden kann. Somit können produktionsrelevante Daten verloren gehen.

Das Dokument JP-A-200495719 offenbart einen Bestichautomaten gemäß dem ersten Teil des Anspruchs 1.

Es ist deshalb die Aufgabe der vorliegenden Erfindung, einen Bestückautomaten, eine Zuführeinrichtung und ein Verfahren zur Steuerung dieses Bestückautomaten zu liefern, welche die Betriebssicherheit des Bestückautomaten erhöhen.

Diese Aufgabe wird durch die Gegenstände der unabhängigen Ansprüche gelöst.

Der erfindungsgemäße Bestückautomat gemäß dem Anspruch 1 umfasst eine lösbare Verriegelungseinrichtung, mit welcher eine Zuführeinrichtung des Bestückautomaten fest mit dem Bestückautomaten gekoppelt werden kann. Des Weiteren umfasst der Bestückautomat eine erste Steuereinrichtung, die mit der Verriegelungseinrichtung derart verbunden ist, dass die Steuereinrichtung die Verriegelungseinrichtung wahlweise verriegeln oder entriegeln kann. Die Verriegelungseinrichtung kann einen Aktuator aufweisen, der von der ersten Steuereinrichtung entsprechend angesteuert wird, um die Verriegelungseinrichtung zu entriegeln oder zu verriegeln. Erfindungsgemäß kann die Verriegelungseinrichtung nur noch durch die erste Steuereinrichtung des Bestückautomaten entriegelt werden und nicht, wie aus dem Stand der Technik bekannt, direkt durch den Bediener. Dies erlaubt der ersten Steuereinrichtung bestimmte Betriebsparameter bzw. Freigabebedingungen vor dem Entriegeln der Verriegelungseinrichtung abzuprüfen, wie beispielsweise die Anwesenheit des Bestückkopfs an der entsprechenden Zuführeinrichtung oder die korrekte Beendigung der Datensicherung auf Seiten der Zuführeinrichtung. Dadurch, dass die Zuführeinrichtung vom Bediener erst nach der Entriegelung durch die erste Steuereinrichtung vom Bestückautomaten entnommen werden kann, wird die Betriebssicherheit des Bestückautomaten erheblich verbessert.

Gemäß einer Ausgestaltung des Bestückautomaten nach Anspruch 2 weist der Bestückautomat eine erste Datenschnittstelle auf, welche von einer entsprechenden zweiten Datenschnittstelle auf Seiten der Zuführeinrichtung nur dann getrennt werden kann, wenn die Verriegelungseinrichtung von der ersten Steuereinrichtung entriegelt ist. Somit wird verhindert, dass ein eventuell momentan stattfindender Datenaustausch zwischen dem Bestückautomaten und der Zuführeinrichtung abrupt durch äußere Einwirkung getrennt wird. Dadurch wird ein Verlust der Daten durch plötzliche Trennung der Datenverbindung verhindert.

Der erfindungsgemäße Bestückautomat kann gemäß Anspruch 3 auch dahingehend ausgestaltet sein, dass er eine Energieschnittstelle aufweist, die von einer entsprechenden zweiten Energieschnittstelle auf Seiten der Zuführeinrichtung nur dann getrennt werden kann, wenn die Verriegelungseinrichtung von der ersten Steuereinrichtung entriegelt worden ist. Dadurch wird gewährleistet, dass die von der Zuführeinrichtung zur Datensicherung nötige Energie so lange vom Bestückautomaten zugeführt wird, bis alle Datensicherungsprozesse oder eventuelle Förderaufträge beendet sind.

Nach einer Ausgestaltung des Bestückautomaten nach Anspruch 4 umfasst die Verriegelungseinrichtung einen beweglich gelagerten Haken, welcher in einer Verriegelungsposition eine Zuführeinrichtung fest an den Bestückautomaten koppelt und in einer Freigabeposition die Zuführeinrichtung freigibt. Ferner weist die Verriegelungseinrichtung ein Federelement auf, welches so angeordnet ist, dass es den Haken durch die Federkraft in die Verriegelungsposition zwingt. Zum Lösen des Hakens aus der Verriegelungsposition in die Freigabeposition weist die Verriegelungseinrichtung ferner einen mit der ersten Steuereinrichtung des Bestückautomaten gekoppelten Aktuator auf, welcher den Haken gegen die Federkraft des Federelements in die Freigabeposition bewegt. Gemäß dieser Anordnung betätigt die erste Steuereinrichtung den Aktuator der Verriegelungseinrichtung nur dann, wenn der Haken in die Freigabeposition bewegt werden soll. Bei Nichtbetätigung des Aktuators wird der Haken durch die Federkraft des Federelements in der Verriegelungsposition gehalten. Somit muss der Aktuator zum Lösen der Verriegelungseinrichtung nur kurzfristig von der Steuerungseinrichtung betätigt werden, was eine energiesparende und sichere Betriebsweise der Verriegelungseinrichtung ermöglicht.

In der Ausgestaltung des erfindungsgemäßen Bestückautomaten gemäß Anspruch 5, kann der Bestückautomat derart ausgestaltet sein, dass mehrere Zuführeinrichtungen daran angeordnet werden können. In diesem Fall ist am Bestückautomaten für jede Zuführeinrichtung eine eigene Verriegelungseinrichtung vorgesehen, mit der jede Zuführeinrichtung individuell ver- und entriegelt werden kann. Dadurch wird verhindert, dass bei Freigabe einer Zuführeinrichtung alle Zuführeinrichtungen entnommen werden können, wie es bei einer gemeinsamen Verriegelungseinrichtung für alle Zuführeinrichtungen der Fall wäre.

Eine Zuführeinrichtung für einen erfindungsgemäßen Bestückautomaten weist gemäß Anspruch 6 eine Betätigungseinrichtung, wie beispielsweise einen Druckknopf bzw. einen Taster auf, die bei einer Betätigung durch den Bediener ein Freigabesignal an die erste Steuereinrichtung des Bestückautomaten übermittelt. Das Freigabesignal zeigt an, dass der Bediener die Zuführeinrichtung entnehmen will und die Steuereinrichtung des Bestückautomaten die Verriegelungseinrichtung freigeben soll. Dadurch, dass die Betätigungseinrichtung zur Übermittlung des Freigabesignals unmittelbar an der entsprechenden Zuführeinrichtung vorgesehen ist, wird immer sichergestellt, dass die richtige Zuführeinrichtung entriegelt wird. Ein Fehler bei der Zuordnung, wie er beispielsweise dann auftreten könnte, wenn die Freigabe der Zuführeinrichtung an einem zentralen Bedienpult des Bestückautomaten durchgeführt werden müsste, kann hierbei nicht auftreten.

Ein Steuerverfahren für einen erfindungsgemäßen Bestückautomaten ist gemäß Anspruch 7 dadurch gekennzeichnet, dass die Steuereinrichtung nach Empfangen eines Freigabesignals, welches die Entriegelung der Verriegelungseinrichtung anfordert, überprüft, ob eine oder mehrere vorgegebene Freigabebedingungen erfüllt sind. Die erste Steuereinrichtung entriegelt die Verriegelungseinrichtung erst dann, wenn sichergestellt ist, dass die eine oder die mehreren Freigabebedingungen erfüllt sind. Als Freigabebedingungen sind alle möglichen sicherheits- oder betriebsrelevanten Ereignisse denkbar. Durch dieses Verfahren wird die Betriebssicherheit des Bestückautomaten erheblich gesteigert, da relevante Betriebsparameter vor der Entriegelung bzw. der Freigabe der Zuführeinrichtung durch die erste Steuereinrichtung des Bestückautomaten abgeprüft werden.

Nach einer Ausgestaltung des Steuerverfahrens gemäß Anspruch 8 kann es vorteilhaft sein, dass die erste Steuereinrichtung als eine Freigabebedingung überprüft, ob sich ein Bestückkopf des Bestückautomaten im Bereich der entsprechenden Zuführeinrichtung befindet, um dort Bauelemente abzuholen. Die Steuereinrichtung entriegelt die Verriegelungseinrichtung erst dann, wenn sichergestellt ist, dass sich der Bestückkopf außerhalb des Abholbereiches des Bestückautomaten bzw. des Bereiches zu Zuführeinrichtung befindet. Dadurch wird eine Kollision der Zuführeinrichtung mit dem Bestückkopf vermieden.

Die Ausgestaltung des Steuerverfahrens gemäß Anspruch 9 ist auf einen Bestückautomaten gerichtet, wie er im Anspruch 2 beschrieben wird, und ist dadurch gekennzeichnet, dass die Verriegelungseinrichtung durch die erste Steuereinrichtung erst dann entriegelt wird, nachdem ein eventuell gerade durchgeführter Datenaustausch über eine Datenschnittstelle zwischen der ersten Steuereinrichtung des Bestückautomaten und der zweiten Steuereinrichtung auf Seiten der Zuführeinrichtung abgeschlossen ist. Dadurch wird eine fehlerfreie Durchführung eines Datenaustausches sichergestellt und ein Datenverlust wird verhindert.

Die Ausgestaltung des Steuerverfahrens nach Anspruch 10 ist auf einen Bestückautomaten gemäß Anspruch 3 gerichtet und besagt, dass die erste Steuereinrichtung die Verriegelungseinrichtung erst dann freigibt, nachdem die zweite Steuereinrichtung auf Seiten der Zuführeinrichtung betriebsrelevante oder produktionsrelevante Daten in einen Datenspeicher gesichert hat. Dadurch wird sichergestellt, dass die Zuführeinrichtung so lange mit elektrischer Energie von Seiten des Bestückautomaten versorgt wird, bis alle Daten in den Datenspeicher abgespeichert sind. Ein Datenverlust wird somit vermieden.

Gemäß einer Ausgestaltung des Steuerverfahrens nach Anspruch 11 wird die Verriegelungseinrichtung durch die erste Steuereinrichtung erst dann entriegelt, nachdem ein aktueller Förderauftrag der Zuführeinrichtung abgeschlossen ist. Funktionsstörungen auf Seiten der Zuführeinrichtung werden somit vermieden.

Das Steuerverfahren kann gemäß Anspruch 12 auch dahingehend ausgestaltet werden, dass die erste Steuereinrichtung die Zuführeinrichtung vor dem Entriegeln der Verriegelungseinrichtung stromlos schaltet. Dies ist als letzter Schritt vor dem Entriegeln der Verriegelungseinrichtung, d. h. vor dem Entnehmen der Zuführeinrichtung durch den Bediener, sinnvoll. Dadurch wird sichergestellt, dass alle Aktivitäten auf Seiten der Zuführeinrichtung vollständig beendet sind, was aus Sicht der Betriebssicherheit vorteilhaft ist.

Gemäß der Ausgestaltung des Steuerverfahrens nach Anspruch 13 wird das Freigabesignal durch Betätigung einer Betätigungseinrichtung auf Seiten der Zuführeinrichtung an die erste Steuereinrichtung abgesandt. Bezüglich der Vorteile wird auf Anspruch 6 verwiesen.

Zur weiteren Steigerung der Betriebssicherheit kann das Steuerverfahren gemäß Anspruch 14 dahingehend ausgestaltet werdne, dass die erste Steuereinrichtung die Verriegelungseinrichtung nur für eine begrenzte Zeitspanne entriegelt und nach Ablauf der Zeitspanne wieder verriegelt. Mit dieser Vorgehensweise wird dem Problem begegnet, dass sich bei Betrieb des Bestückautomaten die Betriebsbedingungen innerhalb einer gewissen Zeit ändern können. Beispielsweise kann sich der Bestückkopf nach gewisser Zeit nun doch in den Abholbereich bewegen oder eine Kommunikation zwischen der ersten und der zweiten Steuereinrichtung aufgenommen werden, was zu Beginn der Zeitspanne noch nicht der Fall war.

Ferner ist es gemäß Anspruch 15 auch möglich, dass die erste Steuereinrichtung die Verriegelungseinrichtung sofort wieder verriegelt, sobald sie erkennt, dass der Bestückkopf in den Abholbereich des Bestückautomaten bzw. in den Bereich der entsprechenden Zuführeinrichtung verfährt.

Der erfindungsgemäße Bestückautomat, die erfindungsgemäße Zuführeinrichtung und das erfindungsgemäße Steuerverfahren werden im Folgenden anhand eines vorteilhaften Ausführungsbeispiels unter Bezug auf die beigefügten Figuren näher erläutert, wobei
Figur 1 eine schematische Darstellung der wesentlichen Teile eines Ausführungsbeispiels eines erfindungsgemäßen Bestückautomaten und einer erfindungsgemäßen Zuführeinrichtung, und
Figur 2 eine perspektivische Teilansicht einer erfindungsgemäßen Zuführeinrichtung darstellt.

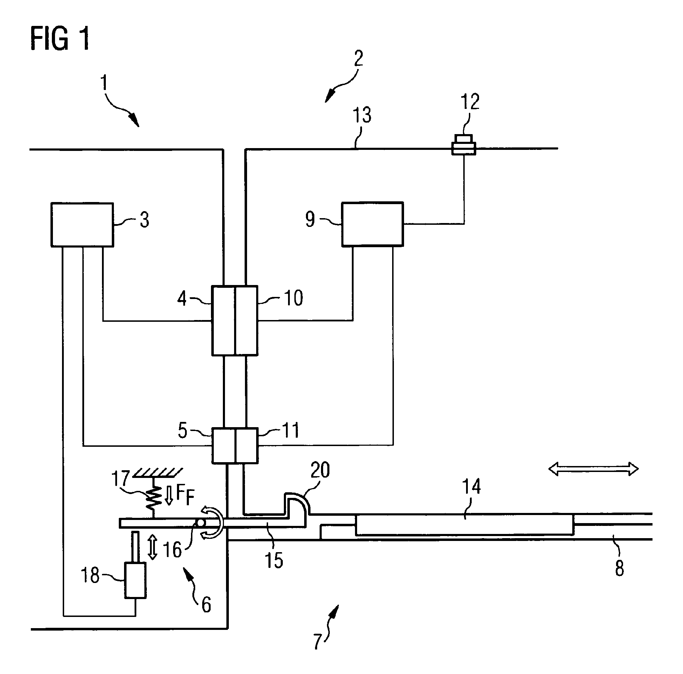

Figur 1 zeigt wesentliche Teile eines Ausführungsbeispiels des erfindungsgemäßen Bestückautomaten 1, an dem eine erfindungsgemäße Zuführeinrichtung 2 angekoppelt ist. Der Bestückautomat 1 (in Figur 1 links dargestellt) verfügt über eine erste Steuereinrichtung 3, eine erste Datenschnittstelle 4, eine erste Energieschnittstelle 5 sowie eine Verriegelungseinrichtung 6 zum Ankoppeln der in Zuführeinrichtung 2 (Figur 1 rechts dargestellt). Sowohl die erste Energieschnittstelle 5 als auch die erste Datenschnittstelle 4 sind mit der ersten Steuereinrichtung 3 elektrisch verbunden. Die erste Steuereinrichtung 3 ist ferner mit einem Bestückkopf und einem Positioniersystem des Bestückkopfs (beide nicht dargestellt) elektrisch verbunden. Der Bestückautomat 1 umfasst des Weiteren einen Tisch 7 zur Befestigung von Zuführeinrichtungen 2, auf dessen Oberseite Führungsschienen 8 für eine oder mehrere Zuführeinrichtungen 2 vorgesehen sind.

Die erfindungsgemäße Zuführeinrichtung 2 verfügt ihrerseits über eine zweite Steuereinrichtung 9, eine zweite Datenschnittstelle 10, eine zweite Energieschnittstelle 11 und ein Betätigungselement 12, beispielsweise in Form eines Tasters 12, auf der Oberseite eines Gehäuses 13 der Zuführeinrichtung. Die zweite Datenschnittstelle 10, die zweite Energieschnittstelle 11 und der Taster 12 sind jeweils mit der zweiten Steuereinrichtung 9 elektrisch verbunden. An der Unterseite des Gehäuses 13 der Zuführeinrichtung 2 ist ein zu den Führungsschienen 8 des Bestückautomaten 1 komplementäres Führungselement 14 vorgesehen, welches die Führungsschienen 8 umgreift. Dadurch ist zwar ein Verschieben der Zuführeinrichtung 2 entlang der Führungsschiene 8 möglich, ein senkrechtes Abheben der Zuführeinrichtung 2 wird dagegen verhindert. Zum Anbringen der Zuführeinrichtung 2 an dem Bestückautomat 1 wird demnach die Zuführeinrichtung 2 mittels des Führungselements 14 auf die Führungsschiene 8 aufgesetzt und in einer durch in Figur 1 durch Pfeile dargestellten Richtung an den Bestückautomaten 1 herangeschoben.

Im Ausführungsbeispiel umfasst die Verriegelungseinrichtung 6 des Bestückautomaten 1 einen sich in Richtung der Zuführeinrichtung 2 erstreckenden Haken 15, welcher um eine Drehachse 16 drehbar am Bestückautomaten 1 gelagert ist (in Fig. 1 durch einen runden Doppelpfeil dargestellt). Auf der bezüglich der Drehachse 16 linken Seite des Hebels des Hakens 15 ist ein Federelement 17, beispielsweise eine Spiralfeder oder eine Torsionsfeder, derart vorgesehen, dass durch die Federkraft auf dem Haken 15 ein im Gegenuhrzeigersinn gerichtetes Drehmoment wirkt. Ferner weist die Verriegelungseinrichtung 6 einen mit der ersten Steuereinrichtung 3 verbundenen Aktuator 18 auf, der bei Ansteuerung durch die erste Steuereinrichtung 3 den Haken 15 gegen die Federkraft des Federelements 17 im Urzeigersinn dreht. Der Aktuator 18 kann beispielsweise durch einen pneumatisch betätigten Zylinder, einen Elektromotor oder einen Elektromagneten realisiert werden.

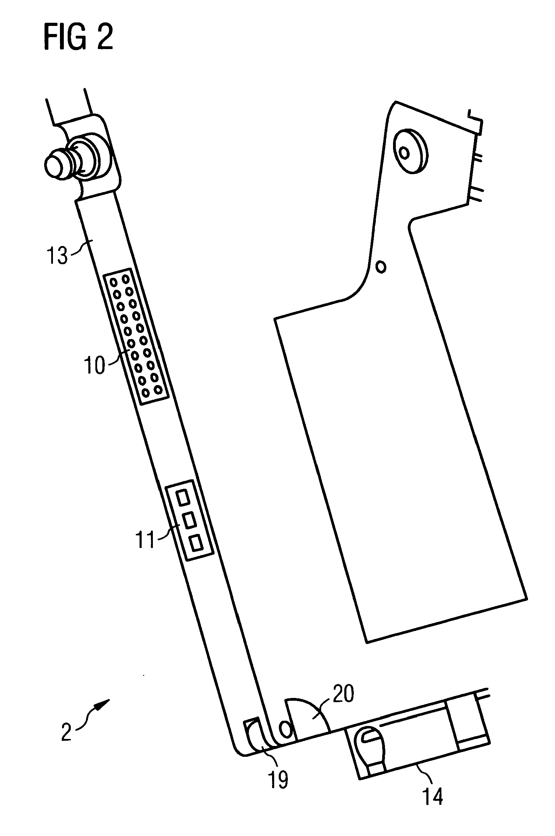

Wird nun die Zuführeinrichtung 2 entlang der Führungsschienen 8 an den Bestückautomaten 1 herangefahren, ist der Aktuator 18 der Verriegelungseinrichtung 6 nicht aktiv, so dass der Haken 15 im Gegenuhrzeigersinn durch die Federkraft belastet ist. Irgendwann stößt die Zuführeinrichtung 2 mit ihrer linken unteren Kante gegen den Haken 15, welcher aufgrund seiner abgerundeten Flanke nach unten ausweicht, so dass die Zuführeinrichtung 2 weiter gegen den Bestückautomaten 1 verschoben werden kann. Ferner kann die Zuführeinrichtung 2, wie in Figur 2 dargestellt, an der linken unteren Kante eine Rolle 19 aufweisen, welche das Überrollen des Hakens 15 weiter erleichtert. In einem Zustand, in dem die Zuführeinrichtung 2 vollständig an den Bestückautomaten 1 herangefahren ist, sind sowohl die erste Datenschnittstelle 4 mit der zweiten Datenschnittstelle 10 als auch die erste Energieschnittstelle 5 mit der zweiten Energieschnittstelle 11 gekoppelt. Wie in Fig. 2 dargestellt, sind im Ausführungsbeispiel der Erfindung die Energieschnittstellen 5,11 und die Datenschnittstellen 4,10 als Steckerverbindungen ausgeführt. An der Unterseite des Gehäuses 13 der Zuführeinrichtung 2 ist eine Vertiefung 20 in einem definierten Abstand von der dem Bestückautomaten 1 zugewandten Kante des Gehäuses 13 vorgesehen, das in einem Zustand, in dem die Zuführeinrichtung 2 vollständig an den Bestückautomaten 1 herangefahren ist und die Datenschnittstellen 4,10 bzw. die Energieschnittstellen 5,11 miteinander gekoppelt sind, der Haken 15 in die Vertiefung 20 einrastet. Diese Position des Hakens 15 der Verriegelungseinrichtung 6 wird im Folgenden als die Verriegelungsposition bezeichnet. Nach dem Einrasten des Hakens 15 in die Vertiefung 20 am Gehäuse 13 der Zuführeinrichtung kann die Zuführeinrichtung 2 durch den Bediener nicht mehr nach hinten herausgezogen werden. Da die Datenschnittstellen 4,10 und die Energieschnittstellen 5,11, wie in Figur 2 dargestellt, an der dem Bestückautomaten 1 zugewandten Vorderseite des Gehäuses 13 angebracht sind und deshalb im gekoppelten Zustand nicht mehr zugänglich sind, ist es dem Bediener nicht mehr möglich, die Datenschnittstellen 4,10 und die Energieschnittstellen 5,11 ohne Weiteres zu trennen.

Ferner ist es vorteilhaft, dass sich der Verankerungspunkt der Verriegelungseinrichtung 6 möglichst nahe an den Datenschnittstellen 4,10 bzw. den Energieschnittstellen 5,11 und/oder an der Abholposition der Zuführeinrichtung 2 befindet, da dadurch eine stabile Fixierung der Datenschnittstellen 4,10 und Energieschnittstellen 5,11 bzw. eine hohe Positionsgenauigkeit der Abholposition gewährleistet ist.

Zum Entfernen der Zuführeinrichtung 2 vom Bestückautomaten 1 muss der Bediener den an der Oberseite der Zuführeinrichtung 2 angebrachten Taster 12 betätigen, was von der zweiten Steuereinrichtung 9 erkannt wird. Daraufhin sendet die zweite Steuereinrichtung 9 über die zweite Datenschnittstelle 10 ein Freigabesignal, welches den Wunsch des Bedieners zur Freigabe der Zuführeinrichtung 2 anzeigt, an die erste Steuereinrichtung 3 des Bestückautomaten 1. Nachdem die erste Steuereinrichtung 3 das Freigabesignal erhalten hat, überprüft sie, ob vorgegebene Freigabebedingungen erfüllt sind. Als Freigabebedingungen sind alle sicherheitstechnischen oder betriebstechnischen Zustände bzw. Betriebsparameter denkbar und können mittels Programmcode selektiv in die erste Steuereinrichtung 3 eingespielt werden.

Im Ausführungsbeispiel überprüft die erste Steuereinrichtung 3 zunächst, ob sich ein Bestückkopf (nicht dargestellt) des Bestückautomaten 1 im Abholbereich des Bestückautomaten 1, d. h. in einem Bereich, in dem die Zuführeinrichtungen 2 am Bestückautomaten 1 angebracht sind, befindet. Befindet sich der Bestückkopf gerade im Bereich der zu entfernenden Zuführeinrichtung 2, d. h. ist der Bestückkopf gerade dabei, ein Bauelement von der Zuführeinrichtung 2 abzuholen, so verbleibt die Verriegelungseinrichtung 6 so lange verriegelt, bis sich der Bestückkopf wieder aus dem Abholbereich entfernt hat. Dadurch wird verhindert, dass durch ein Herausziehen der Zuführeinrichtung 2 ein Schaden am Bestückkopf bzw. an der Zuführeinrichtung 2 auftritt. Nachdem die erste Steuereinrichtung 3 erkannt hat, dass sich der Bestückkopf außerhalb des Gefahrenbereichs, d.h. außerhalb des Abholbereichs der Zuführeinrichtung 2 befindet, wird der Aktuator 18 der Verriegelungseinrichtung 6 von der ersten Steuereinrichtung 3 derart angesteuert, dass er den Haken 15 entgegen der Federkraft im Urzeigersinn bewegt, so dass sich dieser aus der Vertiefung 20 am Gehäuse 13 der Zuführeinrichtung herausbewegt und damit die Zuführeinrichtung 2 freigibt. Die Position des Hakens 15 wird nachfolgend auch als Freigabeposition bezeichnet. Befindet sich der Haken 15 in der Freigabeposition, so kann die Zuführeinrichtung 2 vom Bediener herausgezogen werden. Die Freigabe der Zuführeinrichtung 2 kann beispielsweise durch ein optisches Signal, wie das Aufleuchten einer grünen Leuchtdiode an der Zuführeinrichtung 2 angezeigt werden. Auch ein akustisches Signal wäre denkbar.

Es ist jedoch auch möglich, dass die Steuereinrichtung vor der Freigabe der Verriegelungseinrichtung 6 noch weitere Freigabebedingungen abprüft. So kann es beispielsweise sinnvoll sein, dass die erste Steuereinrichtung 3 die Verriegelungseinrichtung 6 erst dann entriegelt, wenn ein Datenaustausch zwischen der ersten Steuereinrichtung 3 und der zweiten Steuereinrichtung 9 abgeschlossen ist. Dadurch wird ein Datenverlust verhindert. Genauso kann es vorteilhaft sein, die Verriegelungseinrichtung 6 erst dann zu entriegeln, wenn die zweite Steuereinrichtung 9 produktionsrelevante Daten der Zuführeinrichtung 2, wie beispielsweise die Anzahl und die Art der geförderten Bauteile, Betriebsstunden und Fehlermeldungen, in einen Datenspeicher abgespeichert hat. Dies kann dadurch realisiert werden, dass die zweite Steuereinrichtung 9 bei Betätigung des Tasters 12 beginnt, produktionsrelevante Daten von einem flüchtigen Speicher der zweiten Steuereinrichtung 9 in einen nichtflüchtigen Speicher abzusichern und bei vollendeter Datensicherung ein entsprechendes Signal über die Datenschnittstelle an die erste Steuereinrichtung 3 sendet. Diese kann dann die Verriegelungseinrichtung 6 entriegeln. Dadurch wird gewährleistet, dass die zweite Steuereinrichtung 9 so lange mit der Energieversorgung des Bestückautomaten 1 verbunden bleibt bis die Datensicherung verlässlich durchgeführt ist. Ferner kann vor der Entriegelung der Verriegelungseinrichtung 6 noch geprüft werden, ob eventuell gerade ein Förderprozess der Zuführeinrichtung 2 durchgeführt wird. Um Funktionsfehler der Zuführeinrichtung 2 zu vermeiden, wird die erste Steuereinrichtung 3 die Verriegelungseinrichtung 6 erst dann entriegeln, wenn der Förderprozess der Zuführeinrichtung 2 abgeschlossen ist.

Nachdem alle nötigen Bedingungen zur Freigabe der Zuführeinrichtung 2 erfüllt sind, kann die erste Steuereinrichtung 3 die betroffene Zuführeinrichtung 2 von der Energieversorgung trennen, d.h. stromlos schalten.

Eine weitere Steigerung der Betriebssicherheit kann dadurch erreicht werden, dass die erste Steuereinrichtung 3 die Verriegelungseinrichtung 6 nur für eine begrenzte Dauer, beispielsweise einige Sekunden, entriegelt. Wird die Zuführeinrichtung 2 in diesem Zeitraum nicht vom Bestückautomaten 1 entnommen, so verriegelt die erste Steuereinrichtung 3 die Verriegelungseinrichtung 6 wieder. Hintergrund dieser zeitlich begrenzten Freigabe ist, dass sich bei Betrieb des Bestückautomaten 1 die Betriebsbedingungen innerhalb einer gewissen Zeit ändern können. Beispielsweise kann sich der Bestückkopf nach gewisser Zeit doch in den Abholbereich bewegen oder eine Kommunikation zwischen der ersten und der zweiten Steuereinrichtung 9 aufgenommen werden, was zum Zeitpunkt der Prüfung der Freigabebedingungen noch nicht der Fall war. Zum Entnehmen der Zuführeinrichtung 2 muss der Bediener erneut den Taster 12 betätigen, woraufhin wieder alle Freigabebedingungen abgeprüft werden. Dadurch wird sichergestellt, dass die Freigabebedingungen nach einer abgelaufenen Zeitspanne erneut geprüft werden, um den geänderten Bedingungen gerecht zu werden.

Ferner ist es auch möglich, dass die erste Steuereinrichtung 3 die Verriegelungseinrichtung 6 sofort wieder verriegelt, sobald sie erkennt, dass der Bestückkopf in den Abholbereich des Bestückautomaten 1 bzw. in den Bereich der entsprechenden Zuführeinrichtung 2 verfährt. Zur Freigabe der Zuführeinrichtung 2 müsste der Bediener erneut den Taster 12 betätigen.

Dadurch wird eine Kollision der Zuführeinrichtung 2 mit dem sich sehr schnell bewegenden Bestückkopf verhindert.

Analog dazu kann die erste Steuereinrichtung eine Bewegung des Bestückkopfes in den Abholbereich unterbinden, sobald die erste Steuereinrichtung ein Freigabesignal empfängt oder die Verriegelungseinrichtung entriegelt. Auch dadurch wird ein Zusammenstoß des Bestückkopfs mit der Zuführeinrichtung vermieden.

Es ist anzumerken, dass die hier dargestellte Verriegelungseinrichtung 6 nur als Ausführungsbeispiel anzusehen ist. Neben den hier vorgeschlagenen Haken 15 zur Sicherung der Zuführeinrichtung 2 kann genauso gut eine Klemmvorrichtung, bei der die Zuführeinrichtung 2 zwischen zwei entsprechenden Klemmbacken eingeklemmt wird, sowie eine elektromagnetische Fixierung der Zuführeinrichtung 2 an dem Bestückautomaten 1 vorgesehen werden. Die Grundidee der Erfindung liegt jedoch in allen Fällen darin, dass die Hoheit über die Ent- und Verriegelung der Verriegelungseinrichtung 6 auf Seiten der ersten Steuereinrichtung 3 des Bestückautomaten 1 und nicht beim Bediener liegt. Der Bediener kann lediglich einen Freigabewunsch über die Bedienung des Tasters 12 abschicken.

Ferner ist zu beachten, dass falls mehrere Zuführeinrichtungen 2 an dem Bestückautomaten 1 angeordnet werden können, für jede Zuführeinrichtung 2 eine eigene Verriegelungseinrichtung 6 am Bestückautomaten 1 vorgesehen ist, mit der die Zuführeinrichtungen 2 individuell ver- und entriegelt werden können.

Wie aus der Beschreibung des vorherigen Ausführungsbeispiels hervorgeht, ergibt sich durch die vorliegende Erfindung der Vorteil, dass ein Zusammenstoß des Bestückkopfs mit der Zuführeinrichtung 2 durch unachtsames Herausziehen der Zuführeinrichtung 2 ausgeschlossen werden kann. Gleichzeitig wird durch die vorliegende Erfindung die Sicherung wichtiger produktionsrelevanter Daten sichergestellt. Die Stromlosschaltung der Zuführeinrichtung 2 vor dem Entnehmen ist aus Sicherheitsgründen vorteilhaft.

### Bezugszeichenliste

- 1: Bestückautomat
- 2: Zuführeinrichtung
- 3: Erste Steuereinrichtung
- 4: Erste Datenschnittstelle
- 5: Erste Energieschnittstelle
- 6: Verriegelungseinrichtung
- 7: Tisch
- 8: Führungsschienen
- 9: Zweite Steuereinrichtung
- 10: Zweite Datenschnittstelle
- 11: Zweite Energieschnittstelle
- 12: Betätigungselement / Taster
- 13: Gehäuse der Zuführeinrichtung
- 14: Führungselement
- 15: Haken
- 16: Drehachse
- 17: Federelement
- 18: Aktuator
- 19: Rolle
- 20: Vertiefung

## Patentansprüche

1. Bestückautomat (1) zum Bestücken von Substraten mit Bauelementen, mit
einer lösbaren Verriegelungseinrichtung (6), um eine Zuführeinrichtung (2) für elektrische Bauelemente fest mit dem Bestückautomaten (1) zu koppeln, **dadurch gekennzeichnet , dass**
eine erste Steuereinrichtung (3) vorgesehen ist, die mit der Verriegelungseinrichtung (6) derart verbunden ist, dass die Verriegelungseinrichtung (6) durch die erste Steuereinrichtung (3) wahlweise verriegelbar oder entriegelbar ist.

2. Bestückautomat (1) nach Anspruch 1, **dadurch gekennzeichnet, dass** der Bestückautomat (1) eine erste Datenschnittstelle (4) aufweist, welche derart ausgebildet ist, dass sie von einer entsprechenden zweiten Datenschnittstelle (10) auf Seiten der Zuführeinrichtung (2) nur bei entriegelter Verriegelungseinrichtung (6) trennbar ist.

3. Bestückautomat (1) nach einem der Ansprüche 1 bis 2, **dadurch gekennzeichnet, dass** der Bestückautomat (1) eine erste Energieschnittstelle (5) aufweist, welche derart ausgebildet ist, dass sie von einer entsprechenden zweiten Energieschnittstelle (11) auf Seiten der Zuführeinrichtung (2) nur bei entriegelter Verriegelungseinrichtung (6) trennbar ist.

4. Bestückautomat (1) nach einem der Ansprüche 1 bis 3, **dadurch gekennzeichnet, dass** die Verriegelungseinrichtung (6) einen beweglich gelagerten Haken (15) aufweist, um in einer Verriegelungsposition des Hakens (15) die Zuführeinrichtung (2) fest an den Bestückautomaten (1) zu koppeln und in einer Freigabeposition des Hakens (15) die Zuführeinrichtung (2) freizugeben, wobei die Verriegelungseinrichtung (6) ferner ein Federelement (17), welches den Haken (15) in die Verriegelungsposition zwingt, und einen mit der ersten Steuereinrichtung (3) gekoppelten Aktuator (18) aufweist, um den Haken (15) entgegen der Kraft des Federelements (17) in die Freigabeposition zu bewegen.

5. Bestückautomat (1) nach einem der Ansprüche 1 bis 4, **dadurch gekennzeichnet, dass** an den Bestückautomaten (1) weitere Zuführeinrichtungen (2) koppelbar sind, und für jede der Zuführeinrichtungen (2) eine Verriegelungseinrichtung (6) vorgesehen ist, um die Zuführeinrichtungen (2) individuell freizugeben oder an den Bestückautomaten (1) zu koppeln.

6. Zuführeinrichtung (2) für elektrische Bauelemente für einen Bestückautomaten (1) nach Anspruch 1, **gekennzeichnet durch** eine Betätigungseinrichtung, um der ersten Steuereinrichtung (3) des Bestückautomaten (1) ein Freigabesignal zu übermitteln, welches anzeigt, dass die Zuführeinrichtung (2) freigegeben werden soll.

7. Steuerverfahren für einen Bestückautomaten (1) mit
- einer lösbaren Verriegelungseinrichtung (6), um eine Zuführeinrichtung (2) für elektrische Bauelemente fest mit dem Bestückautomaten (1) zu koppeln, und
- einer ersten Steuereinrichtung (3), die mit der Verriegelungseinrichtung (6) derart verbunden ist, dass die Verriegelungseinrichtung (6) durch die erste Steuereinrichtung (3) wahlweise verriegelbar oder entriegelbar ist,
wobei das Verfahren folgende Schritte aufweist:
- Empfangen eines Freigabesignals durch die erste Steuereinrichtung (3) des Bestückautomaten (1), welches anzeigt, dass die Verriegelungseinrichtung (6) entriegelt werden soll,
- Überprüfen durch die erste Steuereinrichtung (3), ob eine oder mehrere Freigabebedingungen erfüllt sind,
- Entriegeln der Verriegelungseinrichtung (6) durch die erste Steuereinrichtung (3), falls die eine oder mehreren Freigabebedingungen erfüllt sind.

8. Steuerverfahren nach Anspruch 7, **dadurch gekennzeichnet, dass** die erste Steuereinrichtung (3) die Verriegelungseinrichtung (6) erst dann entriegelt, wenn sich ein Bestückkopf des Bestückautomaten (1) außerhalb eines Abholbereichs des Bestückautomaten (1), in dem die Zuführeinrichtung (2) angeordnet ist, befindet.

9. Steuerverfahren nach einem der Ansprüche 7 bis 8, wobei der Bestückautomat (1) eine erste Datenschnittstelle (4) aufweist, welche derart ausgebildet ist, dass sie von einer entsprechenden zweiten Datenschnittstelle (10) auf Seiten der Zuführeinrichtung (2) nur bei entriegelter Verriegelungseinrichtung (6) trennbar ist, **dadurch gekennzeichnet, dass** die erste Steuereinrichtung (3) die Verriegelungseinrichtung (6) erst dann entriegelt, nachdem ein Datenaustausch zwischen der ersten Steuereinrichtung (3) auf Seiten des Bestückautomaten (1) und einer zweiten Steuereinrichtung (9) auf Seiten der Zuführeinrichtung (2) abgeschlossen ist.

10. Steuerverfahren nach einem der Ansprüche 7 bis 9, wobei der Bestückautomat (1) eine erste Energieschnittstelle (5) aufweist, welche derart ausgebildet ist, dass sie von einer entsprechenden zweiten Energieschnittstelle (11) auf Seiten der Zuführeinrichtung (2) nur bei entriegelter Verriegelungseinrichtung (6) trennbar ist, **dadurch gekennzeichnet, dass** die erste Steuereinrichtung (3) die Verriegelungseinrichtung (6) erst dann entriegelt, nachdem die zweite Steuereinrichtung (9) betriebsrelevante Daten der Zuführeinrichtung (2) in einem Datenspeicher gesichert hat.

11. Steuerverfahren nach Anspruch 10, **dadurch gekennzeichnet, dass** die erste Steuereinrichtung (3) die Verriegelungseinrichtung (6) erst dann entriegelt, nachdem die Zuführeinrichtung (2) einen aktuellen Förderauftrag abgeschlossen hat.

12. Steuerverfahren nach einem der Ansprüche 10 bis 11, **dadurch gekennzeichnet, dass** die erste Steuereinrichtung (3) die Zuführeinrichtung (2) vor dem Entriegeln der Verriegelungseinrichtung (6) stromlos schaltet.

13. Steuerverfahren nach einem der Ansprüche 7 bis 12, **dadurch gekennzeichnet, dass** die Zuführeinrichtung (2) eine Betätigungseinrichtung aufweist, bei dessen Betätigung das Freigabesignal an die erste Steuereinrichtung (3) gesandt wird.

14. Steuerverfahren nach einem der Ansprüche 7 bis 13, **dadurch gekennzeichnet, dass** die erste Steuereinrichtung (3) die Verriegelungseinrichtung (6) nur für eine begrenzte Zeitspanne entriegelt und nach Ablauf dieser Zeitspanne die Verriegelungseinrichtung (6) wieder verriegelt.

15. Steuerverfahren nach einem der Ansprüche 7 bis 14, **dadurch gekennzeichnet, dass** die erste Steuereinrichtung (3) die Verriegelungseinrichtung (6) sofort verriegelt, sobald sich der Bestückkopf in den Abholbereich bewegt.

## Claims

1. Pick-and-place machine (1) for populating substrates with components, comprising
a detachable locking device (6) for securely coupling a feeder device (2) for electrical components to the pick-and-place machine (1), **characterised in that** a first control device (3) is provided which is connected to the locking device (6) in such a way that the locking device (6) can be optionally locked or unlocked by the first control device (3).

2. Pick-and-place machine (1) according to claim 1, **characterised in that** the pick-and-place machine (1) has a first data interface (4) which is embodied in such a way that it can be separated from a corresponding second data interface (10) on the side of the feeder device (2) only if the locking device (6) is unlocked.

3. Pick-and-place machine (1) according to one of claims 1 to 2, **characterised in that** the pick-and-place machine (1) has a first energy interface (5) which is embodied in such a way that it can be separated from a corresponding second energy interface (11) on the side of the feeder device (2) only if the locking device (6) is unlocked.

4. Pick-and-place machine (1) according to one of claims 1 to 3, **characterised in that** the locking device (6) has a movably mounted hook (15) for the purpose of coupling the feeder device (2) securely to the pick-and-place machine (1) when the hook (15) is in a locking position of and releasing the feeder device (2) when the hook (15) is in a release position, the locking device (6) additionally having a spring element (17) which forces the hook (15) into the locking position, and an actuator (18) coupled to the first control device (3) for the purpose of moving the hook (15) against the force of the spring element (17) into the release position.

5. Pick-and-place machine (1) according to one of claims 1 to 4, **characterised in that** further feeder devices (2) can be coupled to the pick-and-place machine (1) and **in that** a locking device (6) is provided for each of the feeder devices (2) for the purpose of releasing the feeder devices (2) individually or coupling them to the pick-and-place machine (1).

6. Feeder device (2) for electrical components for a pick-and-place machine (1) according to claim 1, **characterised by** an actuating device for the purpose of transmitting a release signal to the first control device (3) of the pick-and-place machine (1), which release signal indicates that the feeder device (2) is to be released.

7. Control method for a pick-and-place machine (1) comprising
- a detachable locking device (6) for the purpose of coupling a feeder device (2) for electrical components securely to the pick-and-place machine (1), and
- a first control device (3) which is connected to the locking device (6) in such a way that the locking device (6) can optionally be locked or unlocked by the first control device (3),
wherein the method comprises the following steps:
- a release signal is received by the first control device (3) of the pick-and-place machine (1), which release signal indicates that the locking device (6) is to be unlocked,
- a check is carried out by the first control device (3) to determine whether one or more release conditions have been met,
- the locking device (6) is unlocked by the first control device (3) if the one or more release conditions have been met.

8. Control method according to claim 7, **characterised in that** the first control device (3) unlocks the locking device (6) only when a placement head of the pick-and-place machine (1) is located outside a picking range of the pick-and-place machine (1) in which the feeder device (2) is arranged.

9. Control method according to one of claims 7 to 8, wherein the pick-and-place machine (1) has a first data interface (4) which is embodied in such a way that it can be separated from a corresponding second data interface (10) on the side of the feeder device (2) only if the locking device (6) is unlocked, **characterised in that** the first control device (3) unlocks the locking device (6) only after a data exchange between the first control device (3) on the side of the pick-and-place machine (1) and a second control device (9) on the side of the feeder device (2) has been completed.

10. Control method according to one of claims 7 to 9, wherein the pick-and-place machine (1) has a first energy interface (5) which is embodied in such a way that it can be separated from a corresponding second energy interface (11) on the side of the feeder device (2) only if the locking device (6) is unlocked, **characterised in that** the first control device (3) unlocks the locking device (6) only after the second control device (9) has saved operationally relevant data of the feeder device (2) in a data memory.

11. Control method according to claim 10, **characterised in that** the first control device (3) unlocks the locking device (6) only after the feeder device (2) has completed a current feeding job.

12. Control method according to one of claims 10 to 11, **characterised in that** the first control device (3) cuts off the power to the feeder device (2) before unlocking the locking device (6).

13. Control method according to one of claims 7 to 12, **characterised in that** the feeder device (2) has an actuating device upon the actuation of which the release signal is sent to the first control device (3).

14. Control method according to one of claims 7 to 13, **characterised in that** the first control device (3) unlocks the locking device (6) for a limited period of time only and locks the locking device (6) again after said period of time has expired.

15. Control method according to one of claims 7 to 14, **characterised in that** the first control device (3) immediately locks the locking device (6) as soon as the placement head moves into the picking range.

## Revendications

1. Automate de pose (1) pour poser des composants sur des substrats, avec un dispositif de verrouillage amovible (6) pour coupler fixement à l'automate de pose (1) un dispositif d'amenée (2) pour des composants électriques, **caractérisé en ce qu'**est prévu un premier dispositif de commande (3) qui est relié de manière telle au dispositif de verrouillage (6) que le dispositif de verrouillage (6) est verrouillable ou déverrouillable, au choix, par le premier dispositif de commande (3).

2. Automate de pose (1) selon la revendication 1, **caractérisé en ce que** l'automate de pose (1) comporte une première interface de données (4) qui est réalisée de manière telle qu'elle ne peut être séparée d'une deuxième interface de données (10) correspondante, du côté du dispositif d'amenée (2), que si le dispositif de verrouillage (6) est déverrouillé.

3. Automate de pose (1) selon l'une des revendications 1 à 2, **caractérisé en ce que** l'automate de pose (1) comporte une première interface d'énergie (5) qui est réalisée de manière telle qu'elle ne peut être séparée d'une deuxième interface d'énergie (11) correspondante, du côté du dispositif d'amenée (2), que si le dispositif de verrouillage (6) est déverrouillé.

4. Automate de pose (1) selon l'une des revendications 1 à 3, **caractérisé en ce que** le dispositif de verrouillage (6) comprend un crochet (15) logé mobile pour coupler fixement le dispositif d'amenée (2) à l'automate de pose (1) dans une position de verrouillage du crochet (15) et débloquer le dispositif d'amenée (2) dans une position de déblocage du crochet (15), le dispositif de verrouillage (6) comportant en outre un élément de ressort (17), qui force le crochet (15) dans la position de verrouillage, et un actionneur (18) couplé au premier dispositif de commande (3) pour déplacer le crochet (15) vers la position de déblocage à l'encontre de la force de l'élément de ressort (17).

5. Automate de pose (1) selon l'une des revendications 1 à 4, **caractérisé en ce que** d'autres dispositifs d'amenée (2) peuvent être couplés à l'automate de pose (1) et il est prévu, pour chacun des dispositifs d'amenée (2), un dispositif de verrouillage (6) pour individuellement débloquer les dispositifs d'amenée (2) ou les coupler à l'automate de pose (1).

6. Dispositif d'amenée (2) pour des composants électriques pour un automate de pose (1) selon la revendication 1, **caractérisé par** un dispositif d'actionnement pour transmettre au premier dispositif de commande (3) de l'automate de pose (1) un signal de déblocage qui indique que le dispositif d'amenée (2) doit être débloqué.

7. Procédé de commande pour un automate de pose (1), avec
- un dispositif de verrouillage amovible (6) pour coupler fixement à l'automate de pose (1) un dispositif d'amenée (2) pour des composants électriques et
- un premier dispositif de commande (3) qui est relié de manière telle au dispositif de verrouillage (6) que le dispositif de verrouillage (6) est verrouillable ou déverrouillable, au choix, par le premier dispositif de commande (3),
le procédé comportant les étapes suivantes:
- réception d'un signal de déblocage par le premier dispositif de commande (3) de l'automate de pose (1), lequel indique que le dispositif de verrouillage (6) doit être déverrouillé,
- vérification, par le premier dispositif de commande (3), qu'une ou plusieurs conditions de déblocage sont remplies,
- déverrouillage du dispositif de verrouillage (6) par le premier dispositif de commande (3) si l'une ou les plusieurs conditions de déblocage sont remplies.

8. Procédé de commande selon la revendication 7, **caractérisé en ce que** le premier dispositif de commande (3) ne déverrouille le dispositif de verrouillage (6) que si une tête de pose de l'automate de pose (1) se trouve en dehors d'une zone d'enlèvement de l'automate de pose (1) dans laquelle se trouve le dispositif d'amenée (2).

9. Procédé de commande selon l'une des revendications 7 à 8, l'automate de pose (1) comportant une première interface de données (4) qui est réalisée de manière telle qu'elle ne peut être coupée d'une deuxième interface de données (10) correspondante, du côté du dispositif d'amenée (2), que si le dispositif de verrouillage (6) est déverrouillé, **caractérisé en ce que** le premier dispositif de commande (3) ne déverrouille le dispositif de verrouillage (6) qu'après la terminaison d'un échange de données entre le premier dispositif de commande (3) du côté de l'automate de pose (1) et un deuxième dispositif de commande (9) du côté du dispositif d'amenée (2).

10. Procédé de commande selon l'une des revendications 7 à 9, l'automate de pose (1) comportant une première interface d'énergie (5) qui est réalisée de manière telle qu'elle ne peut être coupée d'une deuxième interface d'énergie (11) correspondante, du côté du dispositif d'amenée (2), que si le dispositif de verrouillage (6) est déverrouillé, **caractérisé en ce que** le premier dispositif de commande (3) ne déverrouille le dispositif de verrouillage (6) qu'après que le deuxième dispositif de commande (9) a sauvegardé, dans une mémoire de données, des données du dispositif d'amenée (2) pertinentes au regard de l'exploitation.

11. Procédé de commande selon la revendication 10, **caractérisé en ce que** le premier dispositif de commande (3) ne déverrouille le dispositif de verrouillage (6) qu'après la terminaison d'un ordre de transport actuel.

12. Procédé de commande selon l'une des revendications 10 à 11, **caractérisé en ce que** le premier dispositif de commande (3) coupe le courant du dispositif d'amenée (2) avant le déverrouillage du dispositif de verrouillage (6).

13. Procédé de commande selon l'une des revendications 7 à 12, **caractérisé en ce que** le dispositif d'amenée (2) comporte un dispositif d'actionnement à l'actionnement duquel le signal de déblocage est envoyé au premier dispositif de commande (3).

14. Procédé de commande selon l'une des revendications 7 à 13, **caractérisé en ce que** le premier dispositif de commande (3) déverrouille le dispositif de verrouillage (6) uniquement pour un laps de temps limité et reverrouille le dispositif de verrouillage (6) après l'expiration de ce laps de temps.

15. Procédé de commande selon l'une des revendications 7 à 14, **caractérisé en ce que** le premier dispositif de commande (3) verrouille immédiatement le dispositif de verrouillage (6) dès que la tête de pose se déplace vers la zone d'enlèvement.
